# EUROPEAN PATENT APPLICATION

(11) **EP 1 885 170 A1**
(43) Date of publication of application: **06.02.2008**
(21) Application number: 07014825.9
(22) Date of filing: 27.07.2007
(51) Int. Cl.: H05K 7/20, H01L 23/36, H01L 23/367

(54) **Electronic device having heat spreader**

(30) Priority: 31.07.2006 CN 200610104119
(71) Applicant: ASUSTeK Computer Inc., Peitou, Taipei (TW)
(72) Inventor: Chu, Hung-Chun, Peitou Taipei (TW); Wu, Chun-Chieh, Peitou Taipei (TW); Lin, Hsi-Feng, Peitou Taipei (TW)
(74) Representative: Arth, Hans-Lothar

(57) **Abstract**

An electronic device includes a circuit board and a heat spreader. The circuit board has a first surface, a second surface, and an electronic component. The first surface is opposite to the second surface, and the electronic component is located on the first surface. The heat spreader is disposed on the circuit board has a first portion, a second portion, and a third portion. The first portion is located on the first surface of the circuit board and contacts the electronic component. The second portion is located on the second surface of the circuit board, and the third portion is connected between the first portion and the second portion.

## Description

### BACKGROUND OF THE INVENTION

### Field of Invention

The present invention relates to an electronic device. More particularly, the present invention relates to an electronic device having a heat spreader with good heat dissipation effect.

### Description of Related Art

In a computer system, an interface card such as a display card or a sound card serves as the data transmission media between human computer interface (HCI) and computer. In order to satisfy the requirements of users and the increasingly powerful computer functions, the data operation of the interface cards have become more and more complex.

When the interface cards process a large quantity of operation data, the heat generated by the electronic components such as chips or memories on the interface card increases, such that the interface cards suffering the over high temperature easily influence the performance of the whole system.

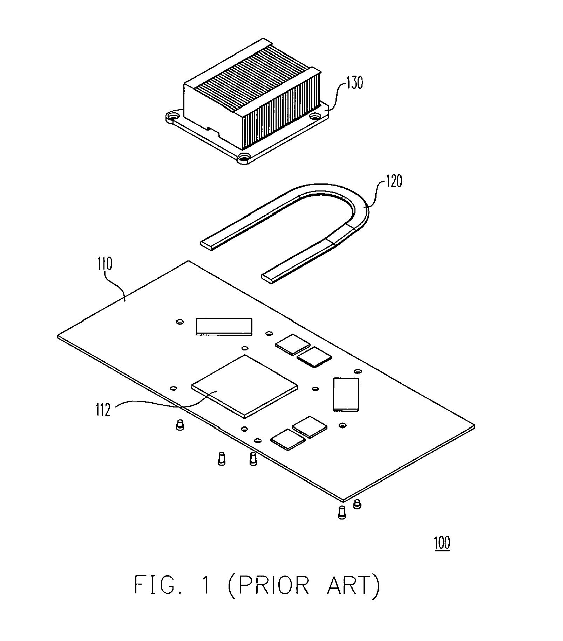

Fig. 1 is an exploded view of a conventional electronic device. Referring to Fig. 1, the electronic device 100 comprises a circuit board 110, a heat pipe 120, and a heat sink 130. The heat pipe 120 and the heat sink 130 are disposed on the circuit board 110, wherein the heat pipe 120 contacts an electronic component 112 on the circuit board 110, and the heat sink 130 is disposed on the heat pipe 120. When the electronic component 112 operates and generates heat, the heat of the electronic component 112 can be conducted to the heat sink 130 through the heat pipe 120, and then conducted to the cool surrounding environment through the heat sink 130. However, due to the limitation of the shape of the heat pipe 130, when the heat of the electronic component 112 is transferred to the heat sink 130, the heat dissipation area provided by the heat pipe 120 is small, thus influencing the heat dissipation effect of the electronic device 100.

### SUMMARY OF THE INVENTION

Accordingly, one of the objects of the present invention is to provide an electronic device having a heat spreader with good heat dissipation effect.

In order to achieve the above or other objects, the present invention provides an electronic device which comprises a circuit board and a heat spreader. The circuit board comprises a first surface, a second surface, and an electronic component, wherein the first surface is opposite to the second surface, and the electronic component is located on the first surface. The heat spreader having a first portion, a second portion, and a third portion is disposed on the circuit board. The first portion is located on the first surface of the circuit board, and contacts the electronic component. The second portion is located on the second surface of the circuit board. The third portion is connected between the first portion and the second portion.

In an embodiment of the present invention, the circuit board further comprises a third surface connected between the first surface and the second surface, and the third portion faces the third surface.

In an embodiment of the present invention, the heat spreader is U-shaped.

In an embodiment of the present invention, the electronic device further comprises a first heat sink disposed on the first portion of the heat spreader.

In an embodiment of the present invention, the electronic device further comprises a second heat sink disposed on the second portion of the heat spreader.

In an embodiment of the present invention, the electronic device further comprises a plurality of fasteners for fastening the heat spreader on the circuit board.

In the electronic device of the present invention, the first portion of the heat spreader is in surface contact with the electronic component, so the heat of the electronic component is quickly conducted to the first portion. Moreover, the heat of the electronic component transferred to the first portion can be conducted to the second portion through the third portion, and then transferred to the cool surrounding environment through the second portion. Therefore, the electronic device has a good heat dissipation effect.

In order to the make aforementioned and other objects, features and advantages of the present invention comprehensible, preferred embodiments accompanied with figures are described in detail below.

### BRIEF DESCRIPTION OF THE DRAWINGS

Fig. 1 is an exploded view of a conventional electronic device.

Fig. 2 is an exploded view of an electronic device having a heat spreader according to an embodiment of the present invention.

Fig. 3 is a schematic view of the electronic device having a heat spreader being assembled on the motherboard.

Figs. 4A and 4B are schematic views of the conducting direction of the heat of the electronic component on the heat spreader.

Fig. 5 is a schematic view of the heat conduction of the heat spreader along line A-A of Fig. 4.

### DESCRIPTION OF EMBODIMENTS

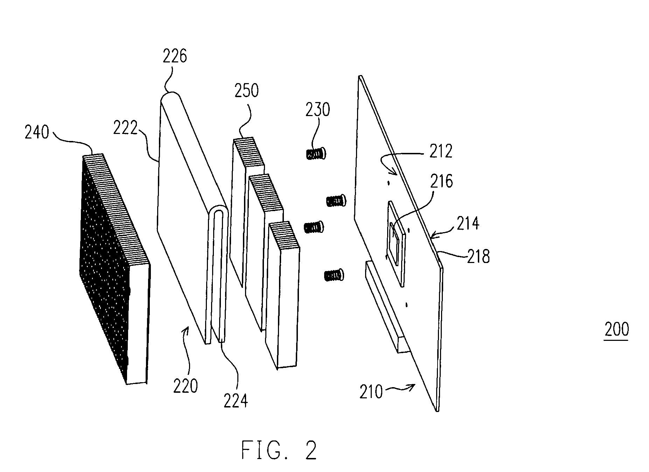

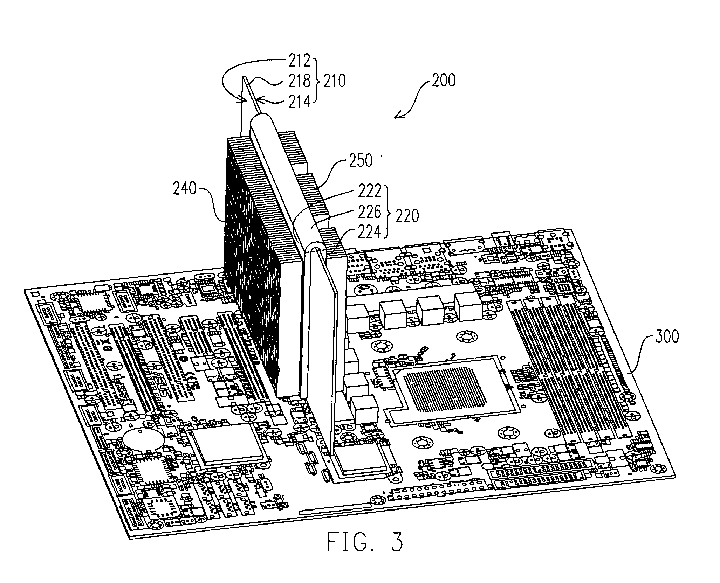

Fig. 2 is an exploded view of an electronic device having a heat spreader according to an embodiment of the present invention, and Fig. 3 is a schematic view of the electronic device having a heat spreader being assembled on the motherboard. Referring to Fig. 2 and Fig. 3, the electronic device 200 of the present embodiment is, for example, an interface card such as a display card or a sound card, which is applicable to being plugged in a motherboard 300. The electronic device 200 comprises a circuit board 210 and a heat spreader 220. The circuit board 210 comprises a first surface 212, a second surface 214, and an electronic component 216, wherein the first surface 212 is opposite to the second surface 214, and the electronic component 216 is located on the first surface 212. Moreover, the heat spreader 220 is disposed on the circuit board 210, and the heat spreader 220 comprises a first portion 222, a second portion 224, and a third portion 226. The first portion 222 of the heat spreader 220 is located on the first surface 212 of the circuit board 210, and contacts the electronic component 216. The second portion 224 is located on the second surface 214 of the circuit board 210. The third portion 226 is connected between the first portion 222 and the second portion 224.

Referring to Fig. 2 and Fig. 3, the circuit board 210 of the present embodiment further comprises a third surface 218, wherein the third surface 218 is connected between the first surface 212 and the second surface 214, and the third portion 226 of the heat spreader 220 faces the third surface 218. As shown in Fig. 3, the heat spreader 220 of the present embodiment is U-shaped, and clamps the circuit board 210. Moreover, the electronic device 200 further comprises a plurality of fasteners 230 for fastening the heat spreader 220 on the circuit board 210. In the present embodiment, the fasteners 230 are screws, but the present invention is not limited to this.

In order to dissipate the heat of the electronic component 216 more quickly, the electronic device 200 further comprises a first heat sink 240 disposed on the first portion 222 of the heat spreader 220. In the present embodiment, the first heat sink 240 has heat sink fins. Likewise, a second heat sink 250 can be disposed on the second portion 224 of the heat spreader 220. The second heat sink 250 also has heat sink fins, so as to enhance the heat dissipation effect of the electronic device 200.

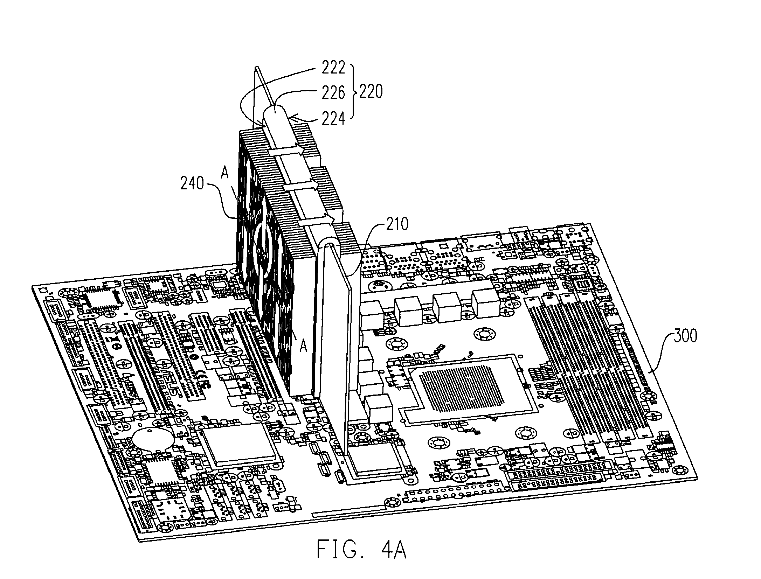

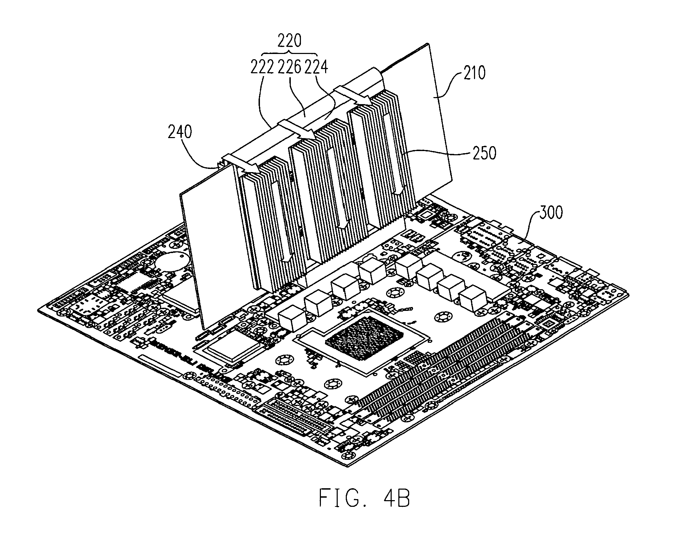

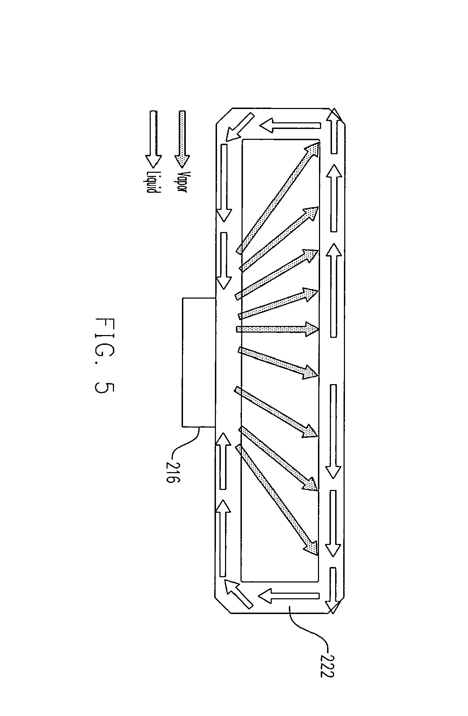

Figs. 4A and 4B are schematic views of the conducting direction of the heat of the electronic component on the heat spreader, and Fig. 5 is a schematic view of the heat conduction of the heat spreader along line A-A of Fig. 4. Referring to Fig. 2, Fig. 4A, Fig. 4B, and Fig. 5, when the electronic component 216 generates heat, the heat of the electronic component 216 is transferred to the first portion 222 of the heat spreader 220, and at this time, the liquid inside the heat spreader 220 is heated to become vapor rising. When the vapor touches the relatively cool end of the first portion 222, the vapor is condensed to liquid flowing downward along the inner wall of the first portion 222, and the heat released by condensing to the liquid is conducted through one relatively cool end of the first portion 222 to the cooler surrounding environment or to the first heat sink 240.

It should be noted that due to the first portion 222 of the heat spreader 220 in surface contact with the electronic component 216, the heat of the electronic component 216 (as shown in Fig. 2) is conducted to the first portion 222 of the heat spreader 220 in a surface diffusion manner. Compared with the conventional art, the heat spreader 220 is attached to the surface of the electronic component 216, thus providing a large heat dissipation area for the electronic component 216 (as shown in Fig. 2), such that the electronic device 200 has an optimal heat dissipation effect.

Moreover, after the heat of the electronic component 216 is conducted to the first portion 222 of the heat spreader 220, a part of the heat may be conducted to the first heat sink 240, and then transferred to the cool surrounding environment. The heat remained on the heat spreader 220 can be conducted to the second portion 224 through the third portion 226, as shown in Fig. 4B, and then transferred to the cool surrounding environment through the second heat sink 250. Therefore, the heat spreader 220 of the electronic device 200 according to the present embodiment has more heat dissipation paths, and thus the electronic component 216 has a better heat dissipation effect than the conventional art.

To sum up, the heat spreader of the electronic device of the present invention provides a larger heat dissipation area for the electronic component, so the electronic device has an optimal dissipating effect. In addition, the heat spreader is U-shaped, so after the heat of the electronic component is conducted to the first portion of the heat spreader, a part of the heat can be transferred to the cool surrounding environment by the heat sink. The remaining heat can be conducted to the second portion through the third portion, and then transferred to the cool surrounding environment through the heat sink. Compared with the conventional art, the electronic device of the present invention has more heat dissipation paths. Therefore, the electronic device of the present invention has a better heat dissipation effect than the conventional electronic device.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. An electronic device, comprising:
a circuit board, having a first surface, a second surface, and an electronic component, wherein the first surface is opposite to the second surface, and the electronic component is located on the first surface; and
a heat spreader, disposed on the circuit board, and having a first portion, a second portion, and a third portion, wherein the first portion is located on the first surface of the circuit board and contacts the electronic component, the second portion is located on the second surface, and the third portion is connected between the first portion and the second portion.

2. The electronic device as claimed in claim 1, wherein the circuit board further comprises a third surface, the third surface is connected between the first surface and the second surface, and the third portion faces the third surface.

3. The electronic device as claimed in claim 1, wherein the heat spreader is U-shaped.

4. The electronic device as claimed in claim 1, further comprising a first heat sink disposed on the first portion of the heat spreader.

5. The electronic device as claimed in claim 1, further comprising a second heat sink disposed on the second portion of the heat spreader.

6. The electronic device as claimed in claim 1, further comprising a plurality of fasteners, for fastening the heat spreader on the circuit board.
